# EUROPEAN PATENT APPLICATION

(11) **EP 2 339 617 A1**
(43) Date of publication of application: **29.06.2011**
(21) Application number: 09180518.4
(22) Date of filing: 23.12.2009
(51) Int. Cl.: H01L 21/78, H01L 21/68

(54) **Method for producing a substrate for use in semiconductor processing**

(71) Applicant: IMEC, 3001 Leuven (BE)
(72) Inventor: Muller, Philippe, F-92800, Puteaux (FR); Buisson, Thibault, B-3001, Leuven (BE); Phommahaxay, Alain, B-3000, Leuven (BE); De Vos, Joeri, B-3400, Neerwinden (BE); Huyghebaert, Cedric, B-3001, Leuven (BE); Jourdain, Anne, B-1390, Grez-Doiceau (BE); Iker, François, B-1435, Mont-Saint-Guibert (BE)
(74) Representative: pronovem

(57) **Abstract**

The present invention is related to a method for manufacturing a substrate suitable for use in semiconductor processing. According to the invention, a substrate is constructed from a smaller sized substrate (1) and a larger sized substrate (2), the larger sized substrate comprising an opening large enough to accommodate the smaller sized substrate. According to the method, both substrates are permanently attached to a carrier (7), which can optionally be thinned so as to have the right dimensions for being handled by semiconductor processing equipment designed for said larger size. The larger substrate therefore does not play the role of a holder for the smaller substrate, but both substrates are assembled to form a new substrate, which can be handled as such. The invention is equally related to such a new substrate, which is obtainable by the methods of the invention.

## Description

### Field of the Invention

The present invention is related to a method for producing a semiconductor substrate of a larger diameter starting from a substrate of a smaller diameter.

### State of the art.

In microelectronics fabrication (including photovoltaic, MEMs, CMOS, etc.), different substrates are used depending on the application and available facilities. These substrates can be made of different materials but also have different dimensions and geometries. A general trend in CMOS manufacturing is to move to larger circular shaped substrates (mostly referred to as wafers). However, not all manufacturers move at the same time to larger diameter wafers, which is why today 150, 200 and 300 mm wafers co-exist in the market. In the photovoltaics industry, most of the time, square substrates are used. If different facilities want to exchange wafers or collaborate on a fabrication process, wafers with equal dimensions must be used to be compatible with the available tools. Starting from larger-sized wafers, downsizing solutions are available. However, if wafers have to move from a smaller to a larger wafer size facility, very limited solutions are offered which generally do not allow using the full process capabilities. Examples of such solutions are shown in US6544033 and US5195729, which illustrate wafer carriers comprising openings in which a substrate may be fitted, the carrier itself being dimensioned such as to be adapted for engagement by equipment for processing wafers. A problem with such techniques is that the surface of the reconstructed wafer is not planar. Also, according to these documents, the carrier is a re-usable holder for the smaller substrate and cannot itself be processed.

### Summary of the invention

The present invention is related to a solution to the abovementioned problems of providing a more reliable way of processing a smaller-sized substrate in a processing environment designed for larger-sized substrates. The invention is particularly related to a method and to a substrate as disclosed in the appended claims.

The method of the invention for manufacturing a substrate suitable for use in semiconductor processing, comprises the steps of :
- providing a first substantially flat substrate, preferably a semiconductor substrate,
- providing a second substantially flat substrate, preferably a semiconductor substrate, having an opening through the complete thickness of said second substrate, the surface corresponding to said opening being larger than the surface of said first substrate,
- temporarily bonding the first and second substrate to a first carrier substrate, wherein the first substrate is placed in said opening, leaving a gap between the first and second substrate,
- filling said gap by a gap-filling material, thereby obtaining an assembly with a front and back side, the carrier being located at the backside and the first and second substrate and gap-filling material being located at the front side of said assembly,
- permanently attaching said assembly to a second carrier substrate by attaching said front side of the assembly to said second carrier substrate,
- removing the first carrier substrate.

Said first substrate and said opening may have the same shape, wherein said first substrate is placed concentrically with respect to said opening. Said first substrate and said opening may have different shapes.

Said step of filling said gap may comprise : depositing a layer of said gap filling material onto said first and second substrate, and performing a planarization step on at least said layer of gap filling material. The method may further comprise the step of planarizing and thinning said first and/or second substrate.

Said step of permanently attaching the assembly may comprise the step of depositing a layer of permanent bonding material onto said front side of said assembly, or onto said second carrier. Said permanent bonding material may be the same as said gap filling material.

The invention is equally related to a substrate suitable for use in semiconductor processing, comprising a carrier substrate, a first substantially flat substrate, and a second substantially flat substrate having an opening through the complete thickness of said second substrate, the surface corresponding to said opening being larger than the surface of said first substrate, the first and second substrate being attached to the same surface of said carrier substrate, the first substrate being arranged within said opening of the second substrate, leaving a gap between the two substrates, and wherein a gap filling material is present in said gap.

Said first substrate and said opening may have the same shape, wherein said first substrate is placed concentrically with respect to said opening. Said first substrate and said opening may have different shapes.

### Brief description of the figures

Figure 1 illustrates a ring-shaped 200mm diameter substrate, which can be used in the method of the invention.

Figures 2 to 5 illustrate the process steps for producing a substrate according to an embodiment of the method of the invention.

### Detailed description of preferred embodiments of the invention

According to the invention, a substrate is constructed from a smaller sized substrate and a larger sized substrate, the larger sized substrate comprising an opening large enough to accommodate the smaller sized substrate. According to the method, both substrates are permanently attached to a carrier, which can optionally be thinned so as to have the right dimensions for being handled by semiconductor processing equipment designed for said larger size. The larger substrate therefore does not play the role of a holder for the smaller substrate, but both substrates are assembled to form a new substrate, which can be handled as such.

The invention is equally related to such a new substrate, which is obtainable by the methods of the invention. Such a substrate comprises a carrier and a first and second substrate attached to one surface of said carrier, the first substrate being arranged within an opening provided in the second substrate, and a suitable gap filling material being present between the two substrates.

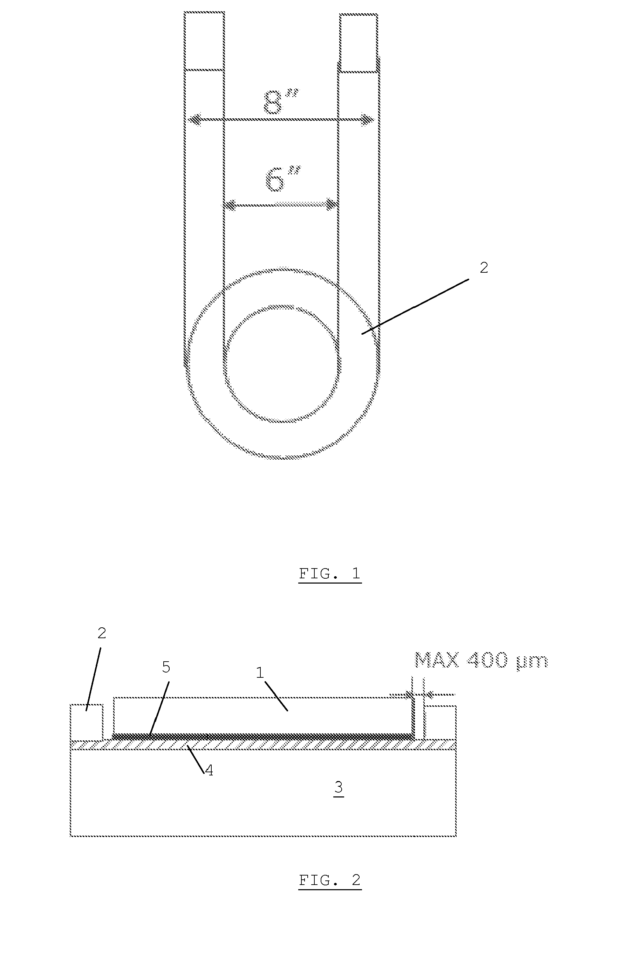

According to a preferred embodiment described hereafter in more detail with reference to the drawings, a standard 150mm silicon wafer is incorporated in a larger ring-shaped 200mm wafer. The invention is not limited to this particular example and applicable to any combination of substrate shapes, while the process steps described hereafter are applicable to all of said combinations. Figure 1 shows a substrate in the form of a ring 2, having an outer diameter of about 200mm and an inner diameter of about 150mm. This substrate can be produced by removing a central circular portion from a standard 200mm (8inch) silicon wafer. This removal can be done by a dicing step according to known methods. The inner diameter of the ring 2 is larger than the diameter of a standard 150mm (6inch) silicon wafer. Preferably, the difference in diameter size between the inner diameter of the ring and the diameter of a standard 6inch-wafer is not larger than 800µm.

As seen in figure 2, the ring-shaped substrate 2, and a standard 6inch silicon wafer 1 are temporarily bonded to a carrier substrate 3, for example a glass substrate or another silicon substrate. The wafer 1 is preferably a device wafer, i.e. a silicon wafer having one 'active' side, carrying or capable of carrying active components (symbolized by layer 5 in the drawing). The active side is brought into contact with a layer 4 of releasable bonding glue, e.g. a wax or any other suitable temporary bonding means known in the art, and applied to the carrier 3 by a technique known in the art, e.g. a spray or spin-on technique. Preferably, the two substrates 1 and 2 are placed concentrically on the carrier, with a maximum distance of 400µm between the outer edge of the wafer 1 and the inner edge of the ring 2. The assembly of the carrier 3 and wafer/ring combination is between about 1mm and 2mm thick, depending on the type of carrier used.

A gap filling material 6 is deposited, so as to fill the gap between the central wafer 1 and the ring 2. The step of depositing the gap filling material may include a curing step according to a known technique, to obtain a stable layer of gap filling material. The gap filling material may be applied by a spray or spin-on technique known in the art. Possibly, a planarization step such as a Chemical Mechanical Polishing step or fly-cutting step can be performed after the deposition (and if applicable, curing) of the gap filling material.

The planarization step may be performed to planarize the layer of gap filling material itself, resulting in a planar layer of gap fill material on the wafer and ring. Particularly when there is a height difference between the ring and wafer, a CMP step may be performed on the wafer and ring themselves (or planarization of the gap fill material continues on the wafer and ring) to make sure that their upper surfaces are in the same plane. Possibly, the planarization continues so as to reduce the thickness of the ring and wafer.

In the example shown in the drawings, the central wafer 1 is higher than the ring 2. After deposition of the gap fill material, a CMP step is done to thin the central wafer 1, and to equalize the upper plane of the wafer and ring, and possibly to further reduce the thickness of the wafer and the ring. Then an additional layer of gap filling material 6 is deposited, which serves as a permanent glue material for attachment to the second carrier (see hereafter). The gap-filling material may be any suitable material with sufficient filling properties. For example, a suitable spin-on polymer may be used, e.g. BCB (benzocyclobutene). A suitable gap filling material is compatible with the carrier material (e.g. glass, Si wafer,...) which is placed onto it (e.g. good sticking) and is capable of withstanding further processing of the assembled substrate. For example, if processing takes place in a furnace at 400°C, the gap filling material needs to be thermally stable up to 400°C. Other examples of such requirements are : resistance to vacuum conditions or resistance to specific chemicals. The gap filling material can also act (if suitable) as a permanent glue.

Hereafter is a list of materials suitable as gap filling material .
- BCB
- Rohm & Haas 8023 (INTERVIA™ PHOTODIELECTRIC 8023 is an insulation resin for advanced packaging applications that can be easily substituted for conventional materials, such as polyimide and BCB.)
- CRC8902
- PDMS (Polydimethylsiloxane (**PDMS**) belongs to a group of polymeric organosilicon compounds **PDMS** is the most widely used silicon-based organic polymer)
- SU8 (**SU-8** is a commonly used epoxy-based negative photoresist. It is a very viscous polymer that can be spun or spread over a thickness ranging from 0.1 micrometer up to 2 millimeters)
- Silicone
- Spin on Glass
- Spin on Oxide
- Sol-Gel materials

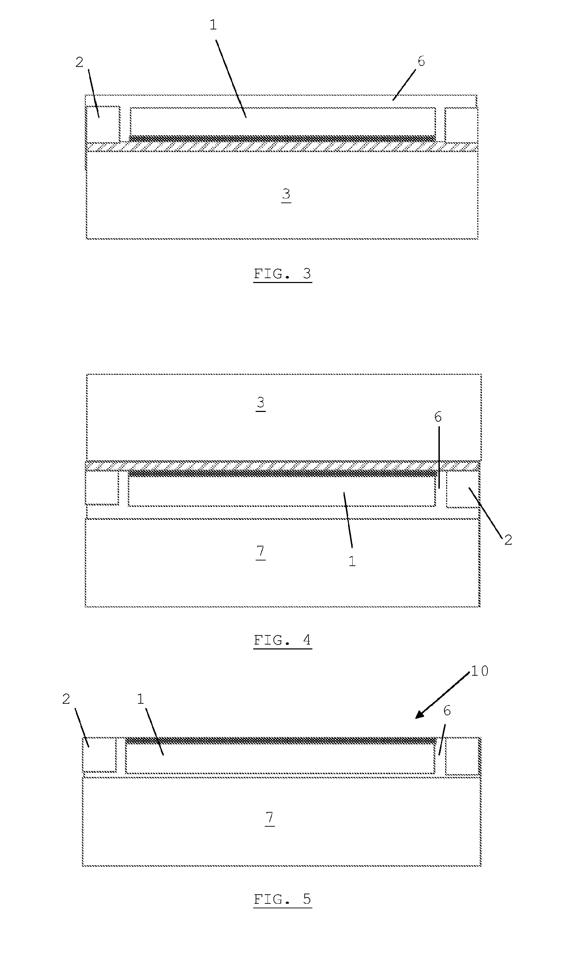

The result, as shown in figure 3, is an assembly of the carrier 3 and the wafer 1 and ring 2, said assembly having a front side (where the wafer and ring are located) and a back side (the back side of the carrier).
The next step is to permanently bond the assembly to a second carrier 7 (e.g. glass or silicon), by attaching the front side to said second carrier. The second carrier 7 may be thinned down before the assembly (1+2+3) is attached to it. For example, the second carrier 7 may be a standard silicon substrate thinned down to a thickness which still allows handling of the substrate. The permanent bond may be obtained by using a permanent glue, deposited on said front side or on the second carrier before attaching the front side to the second carrier. The permanent glue may be the same material as the gap filling material, e.g. BCB. The permanent glue may be deposited by a spray or spin-on technique known in the art. The step of attaching the assembly to the second carrier may include a curing step, for obtaining a stable and permanent bond.

This step may be followed by a thinning step, e.g. grinding with or without a final CMP "fine" polishing step, to thin the second carrier, so as to obtain a substrate (1st carrier + wafer/ring + second carrier) of a given thickness, e.g. 800µm. The purpose of this thinning step is to obtain a final substrate thickness suitable for the processing. In case of wafer processing, the final substrate needs to have a thickness (about) equal to the thickness of a standard silicon wafer.

Then the first carrier is removed, to obtain the final substrate 10, see figure 5. The removal of the first carrier may be done by dissolving the wax used as the temporary bonding means.

The above is an example of the embodiment wherein the cross-section of the opening of the ring 2 has the same shape as the cross section (both cross sections taken perpendicularly to the substrates' surfaces) of the central wafer 1. When the shape of the wafer 1 is the same as the shape of the opening or ring 2, the gap has a constant width and can be filled most easily. This embodiment includes the combination of a rectangular or square opening with a corresponding rectangular or square central wafer (such as used in solar cell substrates for example).

According to another embodiment, these shapes are not equal, for example a rectangular wafer in combination with a circular ring. All the process steps described above remain applicable in this alternative case. Any other combination of shapes is possible within the scope of the present invention.

The main benefit of the method of the invention, compared to other existing solutions (in particular the pocket wafers of US6544033 and US5195729) is that the so fabricated reconstructed wafer is planar (no front side topography). This is achieved thanks to the use of a gap filling material such as a polymer filling the space between the substrate to be processed and the ring. This unique feature allows performing steps such as lithography or continuous metal sputtering (for e.g. seed layers deposition) allowing performing any standard semiconductor processing on top of this reconstructed substrate. It is to be noted that the whole of the reconstructed wafer can be processed, not just the smaller wafer embedded into the larger wafer.

### Example : Process flow for 6" towards 8" wafer reconstruction

As illustrated in figure 1, an annular piece of wafer (2) is thinned to 600 µm and cut out from a standard 8" silicon wafer using a saw dicer. The inner diameter of this piece is 6" +/- some tolerance (400 µm max), allowing easy manipulation in further steps.

Then a support wafer (3) is prepared by spinning a layer (4) of temporary glue (e.g. QS135) on another standard 8" silicon wafer.

As illustrated in figure 2 the annular piece (2) is assembled and aligned to the support wafer (3), possibly with the help of alignment notches on the support wafer and/or the annular piece. Hereby notches and wafers are aligned, minimizing error in tools.

A 6" wafer (1), typical thickness of 650 µm, is then put in the center, with the active side (5) facing the glue layer (4) thereby leaving a gap of maximum 400 µm (depending on the tolerance used to cut out the annular piece).

As illustrated in figure 3 a gap filling material (6), e.g. BCB, can then be applied (by spin coating for example) to the stack.

After curing the material, it is possible to planarize and thin down the stack by mechanical grinding with or without additional CMP.
As illustrated in figure 4 another support wafer (7) is prepared (pre-thinning) and a permanent glue is spun, e.g. BCB, on the second support wafer (7).

The assembly (1) + (2) + (3) is then bonded to the second support wafer (7). The permanent glue is then stabilized by a curing step (250°C for BCB), providing a permanent and stable bond.

As illustrated in figure 5 the carrier (3) is then removed, for instance by chemical dissolution of the temporary glue by acetone.

The reconstructed wafer (1) + (2) + (6) + (7) is then cleaned from residues and the active side (5) can then be further processed.

## Claims

1. A method for manufacturing a substrate suitable for use in semiconductor processing, comprising the steps of :
- providing a first substantially flat substrate (1),
- providing a second substantially flat substrate (2) having an opening through the complete thickness of said second substrate, the surface corresponding to said opening being larger than the surface of said first substrate (2),
- temporarily bonding the first and second substrate to a first carrier substrate (3), wherein the first substrate is placed in said opening, leaving a gap between the first and second substrate,
- filling said gap by a gap-filling material (6), thereby obtaining an assembly with a front and back side, the carrier (3) being located at the backside and the first and second substrate (1,2) and gap-filling material (6) being located at the front side of said assembly,
- permanently attaching said assembly to a second carrier substrate (7) by attaching said front side of the assembly to said second carrier substrate (7),
- removing the first carrier substrate (3).

2. The method according to claim 1, wherein said first substrate (1) and said opening have the same shape and wherein said first substrate is placed concentrically with respect to said opening.

3. The method according to claim 1, wherein said first substrate (1) and said opening have different shapes.

4. The method according to claim 1, wherein said step of filling said gap comprises: depositing a layer of said gap filling material (6) onto said first and second substrate, and performing a planarization step on at least said layer of gap filling material.

5. The method according to claim 4, further comprising the step of planarizing and thinning said first (1) and/or second substrate (2).

6. The method according to claim 1, wherein said step of permanently attaching the assembly comprises the step of depositing a layer of permanent bonding material onto said front side of said assembly, or onto said second carrier (7).

7. The method according to claim 6, wherein said permanent bonding material is the same as said gap filling material (6).

8. A substrate suitable for use in semiconductor processing, comprising a carrier substrate (7), a first substantially flat substrate (1), and a second substantially flat substrate (2) having an opening through the complete thickness of said second substrate (2), the surface corresponding to said opening being larger than the surface of said first substrate (1), the first and second substrate being attached to the same surface of said carrier substrate (7), the first substrate (1) being arranged within said opening of the second substrate (2), leaving a gap between the two substrates, and wherein a gap filling material (6) is present in said gap.

9. The substrate according to claim 8, wherein said first substrate (1) and said opening have the same shape and wherein said first substrate (1) is placed concentrically with respect to said opening.

10. The method according to claim 1, wherein said first substrate (1) and said opening have different shapes.
